# EUROPEAN PATENT APPLICATION

(11) **EP 0 730 165 A2**
(43) Date of publication of application: **04.09.1996**
(21) Application number: 96301444.4
(22) Date of filing: 04.03.1996
(51) Int. Cl.: G01S 7/03

(54) **Integrated microwave circuit board for millimetric wavelengths**

(30) Priority: 03.03.1995 GB 9504259
(71) Applicant: GEC-MARCONI LIMITED, Stanmore, Middlesex HA7 4LY (GB)
(72) Inventor: Sisson, Michael James, Hartley, Wintley, Hampshire, RG27 8TS (GB); Scott, Michael Andrew, Farnborough, Hampshire, GU14 9NH (GB); Khan, Haroon, Teignmouth, Devon, TQ14 9LR (GB)
(74) Representative: Goddin, Jeremy Robert

(57) **Abstract**

All the microwave components involved in generating, transmitting and receiving millimetric microwave signals, including transmit/receive antennae, are integrated on a single soft substrate, the only off-substrate connections comprising DC power and relatively low-frequency control signal paths. Circuit components include a DC blocking capacitor of which one plate is a portion of a strip transmission line conductor (22), the other plate is the overlapping portion of an electrode (202) of a varactor diode PILL package (20), accommodated in a correspondingly-shaped aperture in the soft substrate (210), the dielectric comprising insulating tape (212). A prismatic ferrite circulator housed in a correspondingly-shaped aperture in the substrate may be employed.

## Description

This invention relates to an integrated microwave circuit for use at millimetric wavelengths.

It is known to integrate a number of functions on a substrate at millimetric wavelengths. The substrate generally employed for such wavelengths has been fused or z-cut quartz. This material offers low losses and a low dielectric constant; however quartz is relatively expensive, difficult to machine, and brittle.

The invention arose from an attempt to provide an improved microwave integrated circuit for use at millimetric wavelengths which allows an extremely high degree of integration to be employed.

In accordance with a first aspect of the invention an integrated microwave circuit comprises a soft substrate containing all the microwave circuit elements required to generate, transmit, and receive microwave energy at millimetric wavelengths, whereby the need to provide circuit connections carrying microwave frequencies to and from the substrate is avoided.

In accordance with a second aspect of the invention a circulator for use at millimetric wavelengths comprises:
a soft substrate comprising a plurality of strip transmission lines on one surface thereof;
a prismatic ferrite member having an electrically conductive layer provided on one end face thereof the prismatic member being accommodated in a correspondingly-dimensioned aperture in a soft substrate, the aperture being located at the junction of the transmission lines and having a shape corresponding to and adapted to accommodate therein the prismatic member;
means to make electrical connections between the conductive layer and the ends of the transmission lines adjacent thereto; and
means for establishing a magnetic field substantially normal to the plane of the conductive layer.

In accordance with a third aspect of the invention a capacitor means for providing a DC block between a microwave component and a transmission line coupled thereto, the capacitor means comprising a dielectric layer interposed between first and second plates,
the first plate comprising at least part of the said transmission line,
the dielectric layer comprising a dielectric film superposed on at least the said at least part of the transmission line, and
the second plate comprising at least part of an electrode of the microwave device superposed on the said dielectric film.

In accordance with a fourth aspect of the invention a method of making a capacitor means for providing a DC block between a microwave component and a transmission line, the transmission line comprising a strip line fabricated on a soft substrate, in which one plate of the capacitor means comprises at least part of the transmission line, the other plate comprises at least part of an electrode of the microwave component, the plates being spaced apart by a dielectric layer, the method comprising the steps of:-
(a) applying the dielectric layer over the said part of the transmission line, and
(b) affixing the microwave component to the substrate such that the said electrode is superposed on the dielectric layer.

Embodiments of the invention will now be described by way of non-limiting example only with reference to the drawings in which:
Figure 1 illustrates the relationship between Figures 1a and 1b;
Figures 1a and 1b show a microwave integrated circuit in accordance with the invention;
Figure 2a shows in plan view a frequency doubler in accordance with the invention;
Figure 2b shows a sectioned elevation view of Figure 2a;
Figure 3a shows a plan view of a circulator in accordance with the invention;
Figure 3b shows a partly sectioned elevation view of Figure 3a;
Figure 4 shows a plan view of part of a diode switch;
Figure 5 shows a modification of Figure 3;
Figure 6 shows a modification of Figure 1b; and
Figure 7 shows another microwave integrated circuit in accordance with the invention.

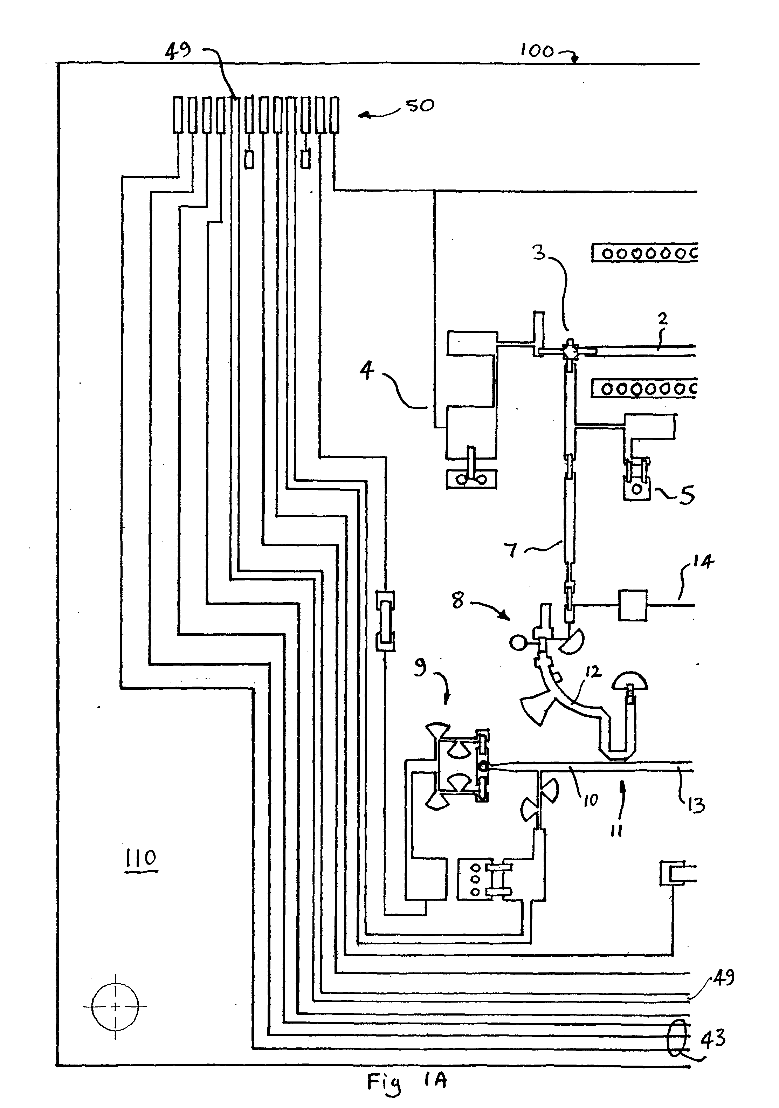

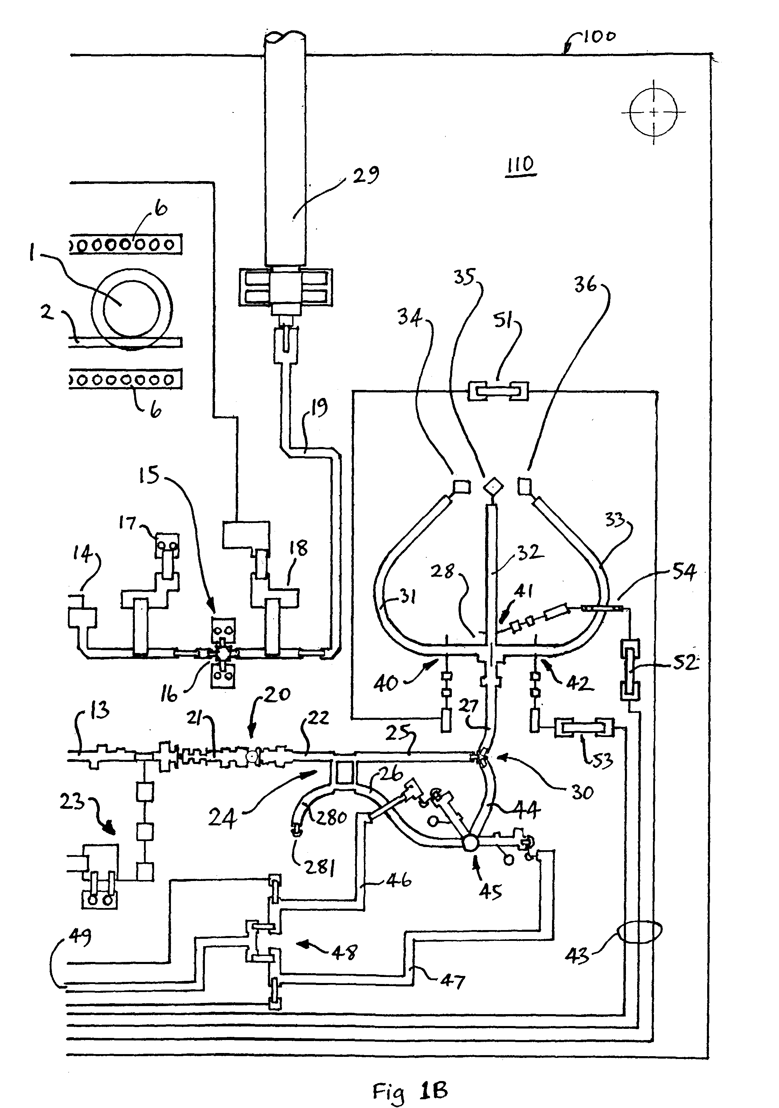

The circuit shown in Figure 1 comprises a 77 GHz millimetre wave sensor for use in an autonomous intelligent cruise system for an automobile. The function of the circuit is to generate, transmit and receive the millimetre wave power. Substantially all the components are contained on one planar microwave integrated circuit using microstrip technology. The components which are integrated are:-
1. Gunn Varactor tuned oscillator at 38-38.5GHz.
2. Varactor-based frequency doubler.
3. Ferrite insert circulator.
4. Single pole 3-way PIN switch.
5. Array of 3 microstrip patch antennae.
6. Branch arm coupler.
7 . Balanced mixer receiver.
8. Parallel line coupler.
9. Harmonic mixer.
10. Dielectric resonator at 12.7 GHz.
11. 150 MHz IF amplifier.
12. Bias feed lines.

The circuit is used in conjunction with a microwave lens, a bias control board, a digital signal processing board and a lineariser circuit. These have not been described or illustrated as they are not relevant to the present invention.

Referring to Figures 1a and 1b, the circuit 100 is fabricated on a soft substrate 110 comprising PTFE/glass fibre material, the lower surface comprising a ground plane, the upper surface having the various transmission lines and other microwave structures fabricated thereon in known manner. In the present embodiment the substrate comprises RT/DUROID 5880 (RTM) having a nominal relative dielectric constant of 2.20, but any equivalent material may be employed. RT/DUROID is a registered trade mark of Rogers Corporation for microwave laminates.

The circuit comprises a first oscillator comprising a dielectric resonator 1, transmission line 2 and oscillator transistor 3 and biasing circuits 4, 5. The dielectric resonator is enclosed by a screening can, not shown, which can is earthed via connections 6 to the earth plane. The oscillator output is conveyed via line 7 to a first mixer 8. A fundamental signal is generated in Gunn oscillator 9 whose output is fed via line 10 and directional coupler 11 to line 13. Part of the fundamental energy is coupled via the coupling branch of coupler 11 and line 12 to harmonic mixer 8 where it is mixed with the third harmonic of the first local oscillator frequency. The resulting IF signal is fed via line 14 to IF amplifier 15 comprising a transistor 16 and biasing circuitry 17, 18. The amplified IF signal is fed via line 19 to coaxial cable 29 and thence to external automatic frequency control circuitry not shown for linearising the Gunn oscillator output in known manner.

The fundamental signal on line 13 which in the present embodiment has a nominal frequency of 38.5 GHz is fed to frequency doubler diode 20 which converts the input frequency on line 13 to an output signal on line 22 at a frequency of 77 GHz, i.e. double that of the input frequency, in known manner. A bias voltage for the frequency doubler 21 is supplied from bias circuit 23. The mounting of the frequency doubler diode will be described in more detail later.

The doubled frequency signal on line 22 is applied to branch arm coupler 24 which produces output signals on its output lines 25, 26. The fourth branch 280 terminates in a terminating resistor for dumping unwanted reflected power in known manner. The signal on line 25 is applied to one port of a three-port ferrite circulator 30 which will be described in more detail later. The input signal on line 25 is coupled to line 27 and thence to a first port of three way switch 28. The second, third and fourth ports of switch 28 are coupled to respective patch antennae 34, 35, 36 via respective transmission lines 31, 32, 33. The switch 28 allows the signal on line 27 to be selectively coupled to any desired one of antennae 34, 35, 36. Each arm 40, 41, 42 of switch 28 comprises a respective stub and pin diode switch as will be described later. DC signals to switch the pin diodes are applied thereto via control lines 43 and respective chip resistors 51, 52, 53. An air bridge 54 couples the DC signal to switch 41.

The signals reflected back to antennae 34, 35, 36 are conveyed via lines 31, 32, 33, and switch 28 to line 27 and thence to circulator 30. The circulator 30 ensures that the received reflected signal is coupled only to line 44.

The signal on line 44 is mixed in second mixer 45 with the signal on line 26 from coupler 24. The resulting IF signal is routed via two parallel paths 46, 47 to combiner 48 thereby producing a combined IF signal on line 49. The combined IF signal is conveyed via line 49 to output connector 50.

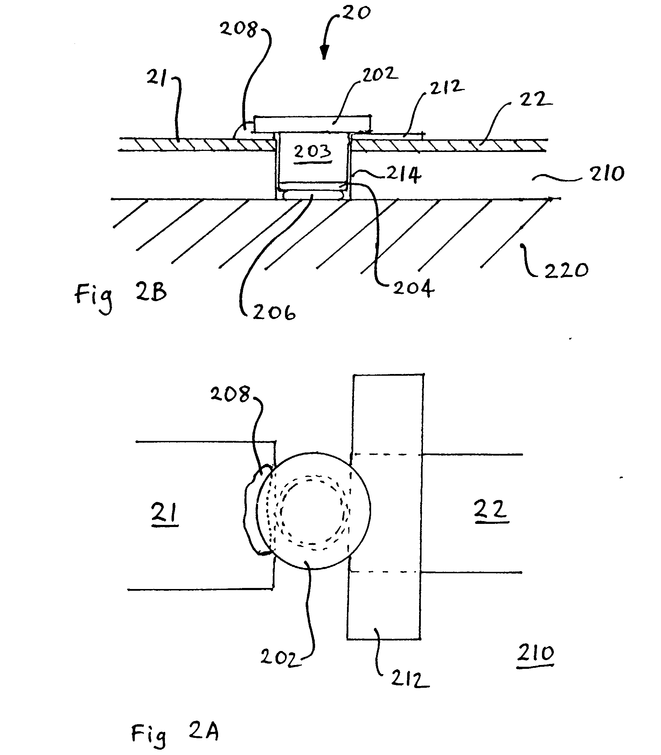

Referring now to Figures 2a and 2b, the doubler diode 20 comprises a conventional PILL package comprising a cylindrical insulating body portion 203, a first conductive electrode 204 of substantially the same diameter as the body portion 203, and a second conductive electrode 202 of larger diameter than the body portion 203. The diode is connected in shunt between lines 21, 22 and ground 220 by inserting it into a hole 214 in the substrate 210. The hole 214 is dimensioned to accommodate the body 203 with a snug fit such that the outer region of electrode 202 overlies the adjacent ends of conductive tracks 21, 22. As is known, in order to function as a doubler a DC bias voltage has to be applied between the first and second electrodes 202, 204 of the doubler diode. In the present embodiment the DC bias is applied via line 21 and biasing circuit 23, as shown in Figure 1. The circuit is completed by making a connection between electrode 204 and ground plane 220 using electrically conductive bonding medium 206 such as silver or gold-loaded epoxy. Similarly, bonding medium 208 is used to make electrical connection between the line 21 and electrode 202.

In the present embodiment it is required to provide DC isolation between the bias voltage on line 21 and the circuitry downstream of diode 20. A conventional way to provide such a DC block is to provide a break in line 22 and connect a chip capacitor across the break. In the present embodiment the need for an auxiliary DC blocking capacitor is avoided in accordance with the invention by providing a dielectric layer 212 over the end of track 22 adjacent the diode and using the capacitance which exist between the electrode 202 and the end of the track 22 immediately thereunder as the DC blocking capacitor. In the present embodiment the dielectric layer 212 is constituted by a strip of Mylar tape applied over the end of track 22 before inserting diode 20 into the hole 214. The bonding medium 206, 208 secures the diode 20 firmly in position in its hole and the capacitance which exist between 202 and 22 via dielectric layer 212 provides the necessary AC signal path and DC block between lines 21 and 22 without requiring a separate capacitor, thereby eliminating both the costs of providing and assembling a discrete capacitor to the circuit board.

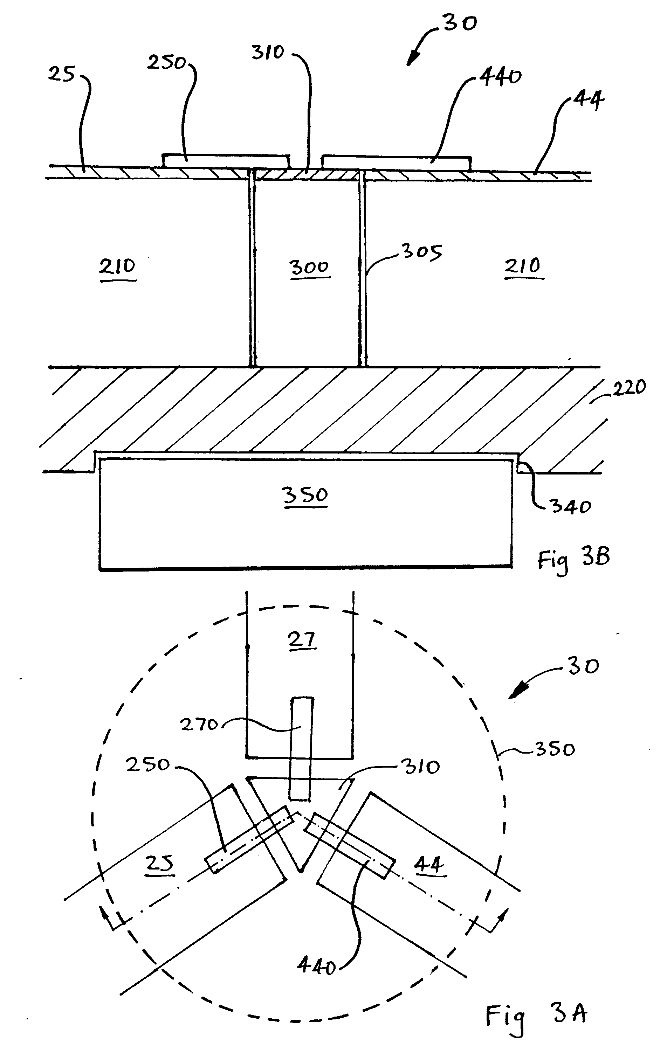

Turning now to Figure 3, a circulator 30 in accordance with the invention comprises a triangular prism 300 of ferrite provided with an electrically conductive layer 310 on one triangular end face thereof. The prism is mounted in a correspondingly-shaped triangular hole 305 in the substrate 210 with a close fit. Hole 305 is conveniently produced by punching using a suitably-shaped punch. Electrical connections between the conductive layer 310 and transmission lines 25, 27, 44 are made via bridging members 250, 270, 440 comprising gold tape. In the present embodiment, the electrical and mechanical connections between the conductive layers 310 and transmission lines 527, 24 are made by thermo-sonic bonding of the gold tape. A magnet 350 is accommodated in a recess 340 on the underside of the ground plane 220 and is arranged to provide a static magnetic field whose lines of force are directed substantially normal to the plane of the substrate at least in the region of space occupied by the conductive layer 310 on the end face of the triangular ferrite insert 300. This provides the circulator with the desired circulating properties. The implementation of the circulator as an integral component of the circuit provides considerable economies of space and cost as compared with prior art circulators for use at millimetric wavelengths. Arrangements in accordance with the invention provide a compact and economical configuration which would be impractical utilising the quartz substrate generally employed hitherto owing to difficulties in manufacture of non-circular holes, therein.

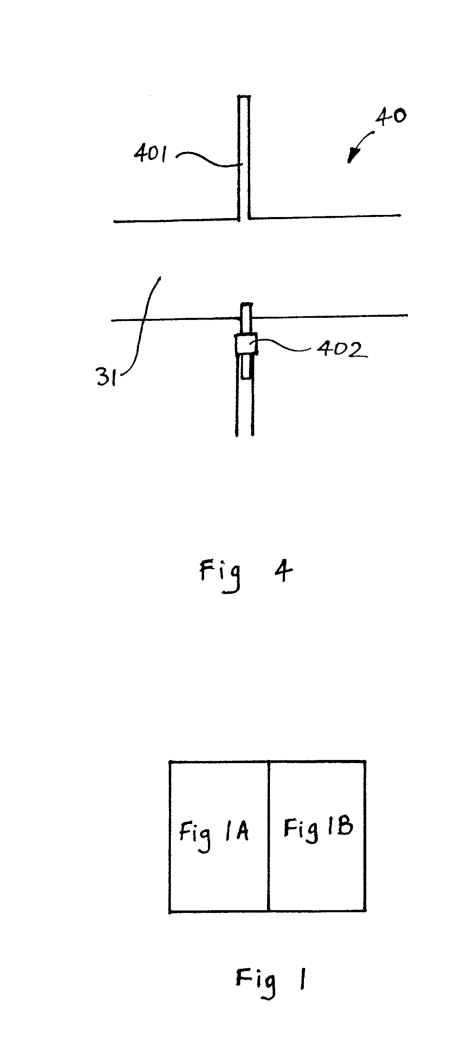

Figure 4 shows one arm 40 of switch 28. The other two arms 41, 42 are substantially identical and have not been shown. The switch comprises a stub line 401 connected to one side of transmission line 31. A pin diode 402 is connected in shunt to the transmission line 31 opposite the stub line 401. The pin diode 402 is biased on or off by the application of an appropriate DC voltage via a circuit, not shown, having a high RF impedance in known manner.

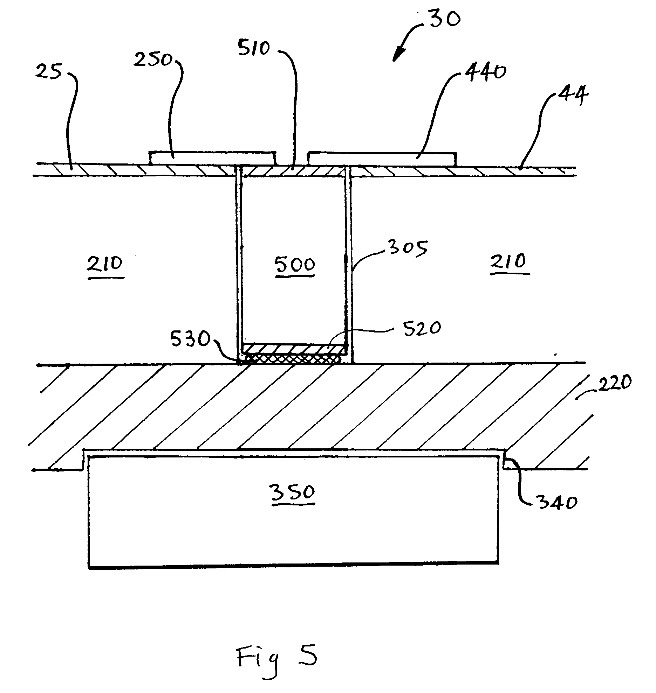

Figure 5 shows a modification of Figure 3. Whereas prism 300 of Figure 3 has metallisation 310 at one end only, as shown in Figure 5, prism 500 has both top metallisation 510 and bottom metallisation 520. Prism 500 is secured in position by electrically conductive epoxy 530, thereby making electrical connection between bottom metallisation 520 and ground plane 220. The other items in Figure 5 are identical with those shown and described in Figure 3 and will not be described further.

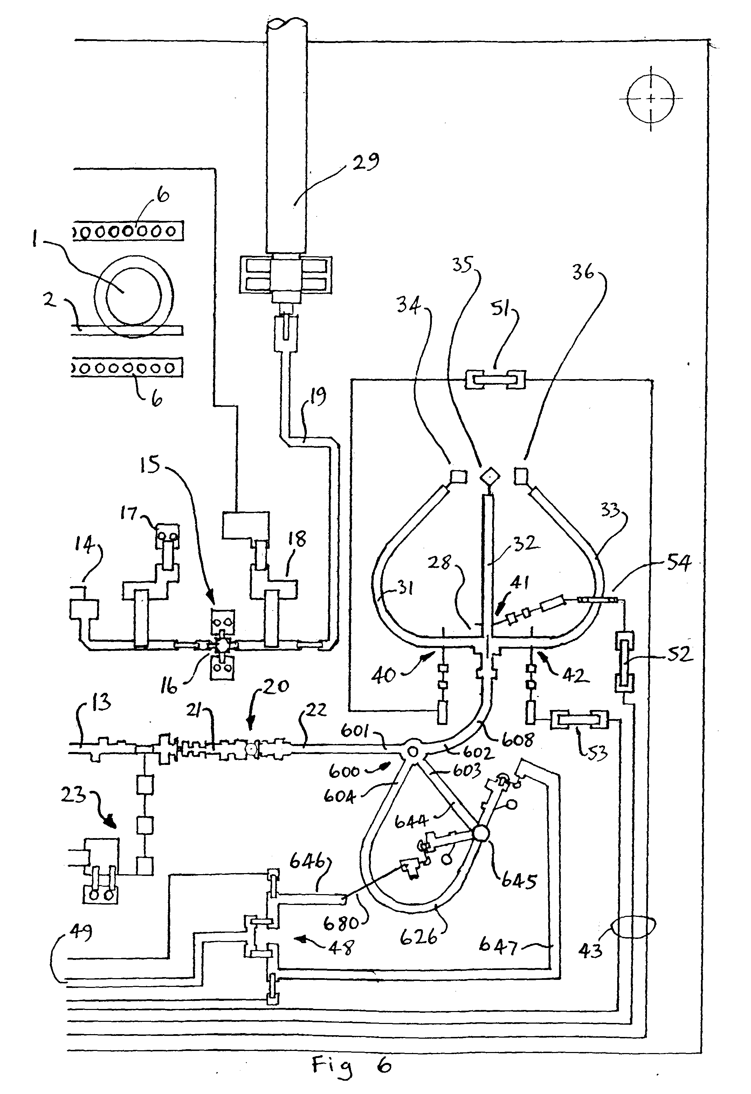

Figure 6 shows a modification of the embodiment of Figure 1. Figure 6 generally corresponds with Figure 1A, but the coupler 24 and ferrite circulator 30 have been replaced by a hybrid junction 600. The frequency doubled signal on line 22 is fed to first port 601 of the hybrid junction 600. The hybrid junction distributes the frequency doubled input signal at first port 601 equally between second port 602 and fourth port 604 in known manner, no LO signal appearing on third port 603. The signal at port 602 is fed via line 608 to switch 41 and thence to a selected antenna 34, 35, 36 in the manner described with reference to Figure 1. The signal at port 604 is fed via line 626 to an input of mixer 645 which is substantially identical with mixer 45 of Figure 1. The reflected signal received by the selected one of antennae 34, 35, 36 is routed via switch 41 and line 608 to second port 602 of hybrid coupler 600. The received signal is equally distributed between first port 601 and third port 603 in known manner. The signal on first port 601 flows towards doubler diode 20 and is lost. The signal on third port 604 passes via line 644 to mixer 645 where it is mixed with the LO signal on line 626. Mixer 645 produces balanced output signals which are supplied to combiner 48 via lines 646 and 647. Lines 646 and 647 correspond to lines 46 and 47 of Figure 1A. Operation is otherwise as described with reference to Figure 1 and will not be described further. While this embodiment does result in a proportion of the received signal being lost, - it has been found to give satisfactory results and offers advantages in respect of simplicity of construction and ease of manufacture.

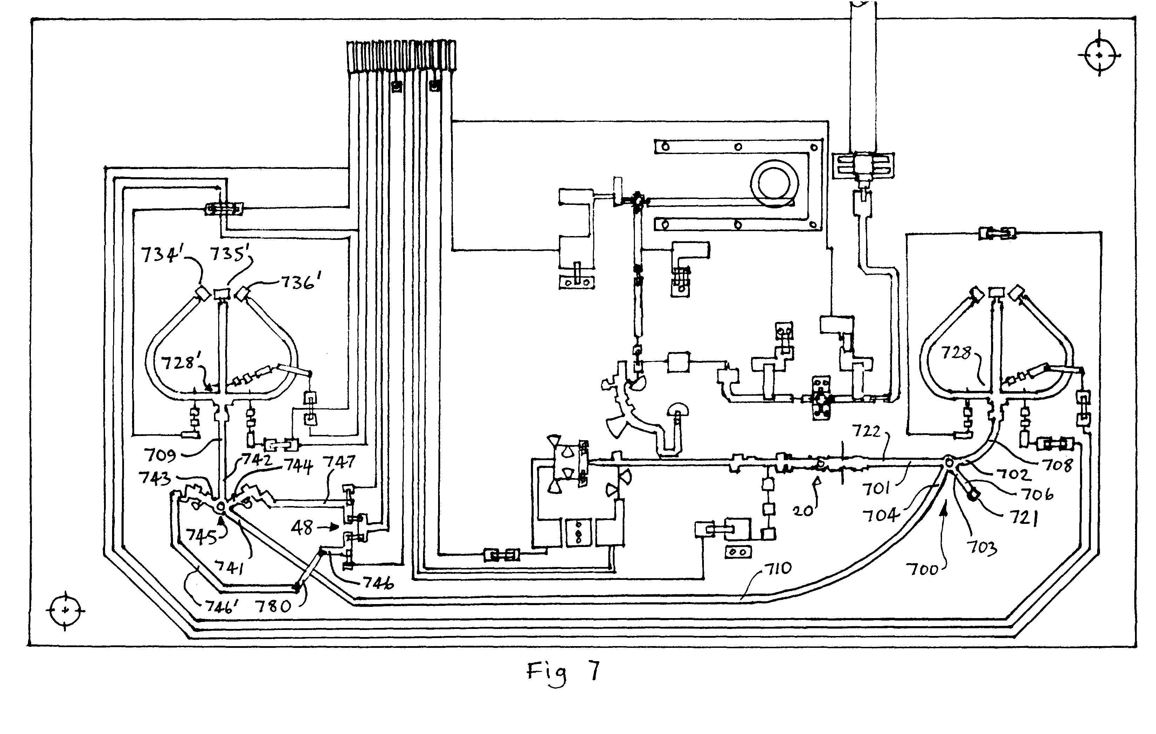

The circuit shown in Figure 7 utilises two antenna arrays, one for receive and one for transmit. As operation is otherwise as described with reference to Figure 1, only the circuitry which is different from the Figure 1 embodiment will be described.

Referring to Figure 7, the microwave circuit has three patch transmit antennae 734, 735, 736, and three patch receive antennae 734', 735', 736'. One of the transmit antennae can be selected by transmit switch 728, and one of the receive antennae can be selected by receive switch 728'. In the present embodiment switches 728 and 728' are ganged so that transmit antenna 734 and receive antenna 734' are selected simultaneously. Similarly transmit and receive antenna pairs 735, 735' and 736, 736' are selected simultaneously. Operation of the individual switches 728, 728' and their associated biassing circuitry is identical with that of switch 28 of Figure 1 and will not be described further.

A signal at a frequency of 38.5 GHz is generated in the manner described with reference to Figure 1 and fed to doubler diode 20. The doubled signal at 77 GHz is fed via line 722 to a first port 701 of a first hybrid coupler 700. The 77 GHz signal at first port 701 is divided between second port 702 and fourth port 704 in known manner. The signal from port 702 is fed via line 708 to transmit switch 728 which routes the signal to a selected one of antennae 734, 735, 736 in the same way that switch 4D of Figure 1 routes signals to antennas 34, 35, 36 and will not be described further. Any reflected signal picked up by a selected one of antennas 34, 35, 36 flows via switch 728 and line 708 to second port 702 of coupler 700. The reflected signal is then distributed between first port 701 and third port 703 in known manner. No received signal appears at fourth port 704. The received signal at first port 701 flows via line 722 to doubler diode 20 and is lost. The received signal at third port 703 passes along line 706 and is dissipated in terminating resistor 721. The 77 GHz signal from diode 20 which emerges from fourth port 704 passes via line 710 to a first input port 741 of mixer 745. The receive switch 728' couples signals from a selected one of receive antennae 734', 735', 736' along line 709 to second input port 742 of mixer 745. The received signal is mixed with the 77 GHz signal at the first port 741 to produce output signals at mixer output ports 743, 744. These signals are fed via line 747 and line 746', air bridge 780 and line 746 to combiner 48.

Thereafter operation is as described with reference to Figure 1 and will not be described further. The receive antennae and the transmit antennae each have to be provided with their own lens, not shown.

A number of modifications are possible within the scope of the invention. The circulator need not be triangular. It may be of any desired prismatic shape according to circuit requirements. If, for example, a four port circulator were required, a right rectangular prism could be employed, mounted in a correspondingly-shaped aperture.

The provision of an aperture for the prism corresponding closely with the shape of the prism offers a number of advantages. A circular hole would leave an air gap between the flat facet of the prism and the arcuate side of the hole. This air gap would of necessity have a different dielectric constant to that of the substrate 210 which could give rise to undesired change of impedance of the transmission line in the vicinity of the circulator.

Bonding need not be by thermo compression bonding but may be by any convenient method. Similarly, bonding media other than conductive epoxy may be employed.

While the embodiments show three antenna elements which can be selectively connected in circuit using switches, the invention may also be performed using greater or lesser numbers of antenna elements for transmission and/or reception. If only one antenna is used it may be possible to dispense with the antenna switch.

## Claims

1. An integrated microwave circuit comprising a soft substrate containing all the circuit elements required to generate, transmit and receive microwave energy at millimetric wavelengths, whereby the need to provide circuit connections carrying microwave frequencies to and from the substrate is avoided.

2. An integrated microwave circuit as claimed in Claim 1 in which the circuit elements comprise oscillator means for generating a microwave frequency; frequency doubler means for producing a doubled microwave frequency from said microwave frequency; antenna means; mixer means; and
multiple-port non-reciprocal circuit means arranged to couple the doubled microwave frequency to said antenna means for transmission thereby and to couple signals received by said antenna means to said mixer means for mixing with the doubled microwave frequency to produce an intermediate frequency signal.

3. An integrated microwave circuit as claimed in Claim 2 in which said antenna means comprises an antenna element arranged to both transmit and receive microwave signals.

4. An integrated microwave circuit as claimed in any preceding claim for transmission and reception of microwave energy at frequencies greater than 70 GHz.

5. A circulator for use at millimetric wavelengths comprising:
a soft substrate comprising a plurality of strip transmission lines on one surface thereof;
a prismatic ferrite member having an electrically conductive layer provided on one end face thereof the prismatic member being accommodated in a correspondingly-dimensioned aperture in a soft substrate, the aperture being located at the junction of the transmission lines and having a shape corresponding to and adapted to accommodate therein the prismatic member;
means to make electrical connections between the conductive layer and the ends of the transmission lines adjacent thereto; and
means for establishing a magnetic field substantially normal to the plane of the conductive layer.

6. A circulator as claimed in Claim 5 in which the means to establish a magnetic field comprises a magnet disposed on the opposite side of the substrate to the conductive tracks.

7. A circulator as claimed in Claim 5 or 6 in which the ferrite member comprises a right triangular prism.

8. A circulator as claimed in any one of Claims 5 to 7 for use at frequencies greater than 70 GHz.

9. A circulator as claimed in Claim 8 for use at frequencies in the range 76 to 78 GHz.

10. A capacitor means for providing a DC block between a microwave component and a transmission line coupled thereto, the capacitor means comprising a dielectric layer interposed between first and second plates,
the first plate comprising at least part of the said transmission line,
the dielectric layer comprising a dielectric film superposed on at least the said at least part of the transmission line, and
the second plate comprising at least part of an electrode of the microwave device superposed on the said dielectric film.

11. A capacitor means as claimed in Claim 10 in which the dielectric layer comprises dielectric tape.

12. A capacitor means as claimed in Claim 11 in which the dielectric comprises Mylar tape.

13. A capacitor means as claimed in Claim 11 or 12 in which the tape is self-adhesive.

14. A capacitor means as claimed in any one of Claims 11 to 13 in which the transmission line comprises microstrip fabricated on a substrate.

15. A capacitor means as claimed in Claim 14 in which the substrate comprises a soft substrate.

16. A capacitor means as claimed in Claim 14 or 15 in which the component is arranged to be mounted in an aperture in the substrate such that the at least part of the electrode extends laterally beyond the aperture in which the component is mounted, the laterally extending portion comprising the second plate.

17. A capacitor means as claimed in Claim 16 wherein the component comprises a PILL package.

18. A method of making a capacitor means for providing a DC block between a microwave component and a transmission line, the transmission line comprising a strip line fabricated on a soft substrate, in which one plate of the capacitor means comprises at least part of the transmission line, the other plate comprises at least part of an electrode of the microwave component, the plates being spaced apart by a dielectric layer, the method comprising the steps of:-
(a) applying the dielectric layer over the said part of the transmission line and
(b) affixing the microwave component to the substrate such that the said electrode is superposed on the dielectric layer.

19. A method as claimed in Claim 18 for a microwave component adapted to be mounted in an aperture in the substrate adjacent the transmission line in which the step of affixing the microwave component to the substrate comprises inserting the component into the aperture such that the said electrode overlaps the said dielectric layer.

20. A method as claimed in Claim 19 in which the step of applying the dielectric layer comprises the application of a tape of dielectric material.

21. A method as claimed in Claim 20 in which the tape is self-adhesive.

22. A method as claimed in any one of Claims 18 to 21 in which the dielectric layer comprises Mylar.
